(19) Europäisches Patentamt
European Patent Office
Office européen des brevets

(11) **EP 0 884 841 B1**

(12) **EUROPEAN PATENT SPECIFICATION**

(45) Date of publication and mention
of the grant of the patent:
**17.12.2008 Bulletin 2008/51**

(51) Int Cl.:
***H03H 9/17*** *(2006.01)*

(21) Application number: **98109650.6**

(22) Date of filing: **27.05.1998**

(54) **Energy-trapped type thickness extensional vibration mode piezoelectric resonator**

Piezoelektrischer Resonator mit eingefangener Energie in Dickenausdehnungsmodus

Résonateur piézoélectrique à piégeage d'énergie en mode d'extension d'épaisseur

(84) Designated Contracting States:
**DE NL**

(30) Priority: **12.06.1997 JP 15528297**

(43) Date of publication of application:
**16.12.1998 Bulletin 1998/51**

(73) Proprietor: **MURATA MANUFACTURING CO., LTD.**
**Nagaokakyo-shi, Kyoto 617-8555 (JP)**

(72) Inventors:
• **KAIDA, Hiroaki**
**c/o Murata Manufacturing Co., Ltd.**
**Nagaokakyo-shi,**
**Kyoto 617 8555 (JP)**
• **YAMADA, Mitsuhiro**
**c/o Murata Manufacturing Co., Ltd.**
**Nagaokakyo-shi,**
**Kyoto 617 8555 (JP)**

• **INOUE, Jiro**
**c/o Murata Manufacturing Co., Ltd.**
**Nagaokakyo-shi,**
**Kyoto 617 8555 (JP)**

(74) Representative: **Laufhütte, Dieter et al**
**Lorenz-Seidler-Gossel**
**Widenmayerstrasse 23**
**80538 München (DE)**

(56) References cited:
**JP-A- 2 235 422          JP-A- 8 242 026**
**US-A- 4 918 350          US-A- 5 045 744**
**US-A- 5 065 066          US-A- 5 925 968**

• **PATENT ABSTRACTS OF JAPAN vol. 010, no. 272 (E-437), 16 September 1986 (1986-09-16) & JP 61 094408 A (NEC CORP), 13 May 1986 (1986-05-13)**

**EP 0 884 841 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to an energy-trapped type piezoelectric resonator used in various resonators, oscillators, and similar devices and, more particularly, to an energy-trapped type thickness extensional vibration mode piezoelectric resonator making use of a harmonic of a thickness extensional vibration mode.

Piezoelectric resonators are used in various piezoelectric resonator parts such as piezoelectric oscillators and piezoelectric filters. Known piezoelectric resonators of this kind utilize various piezoelectric vibration modes, depending on the used frequency.

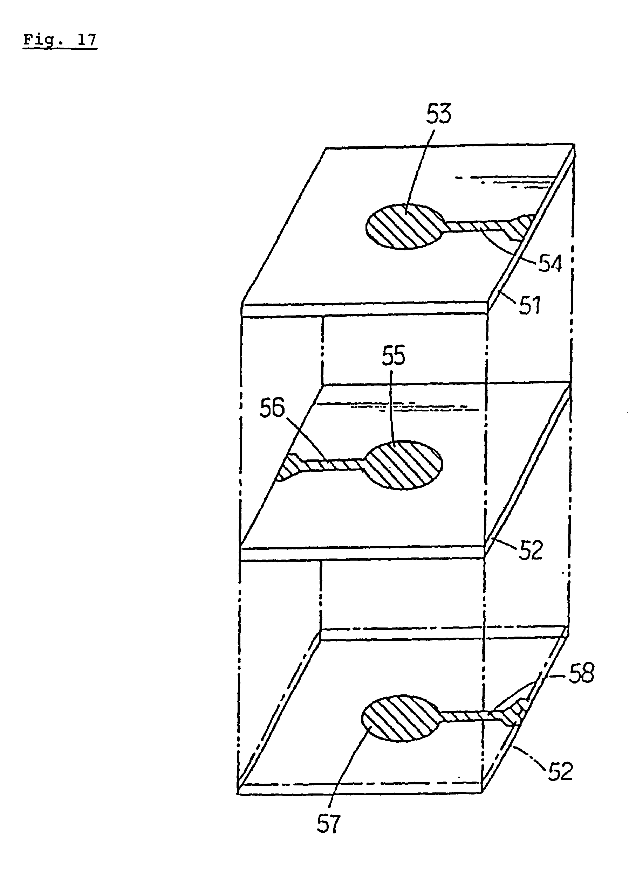

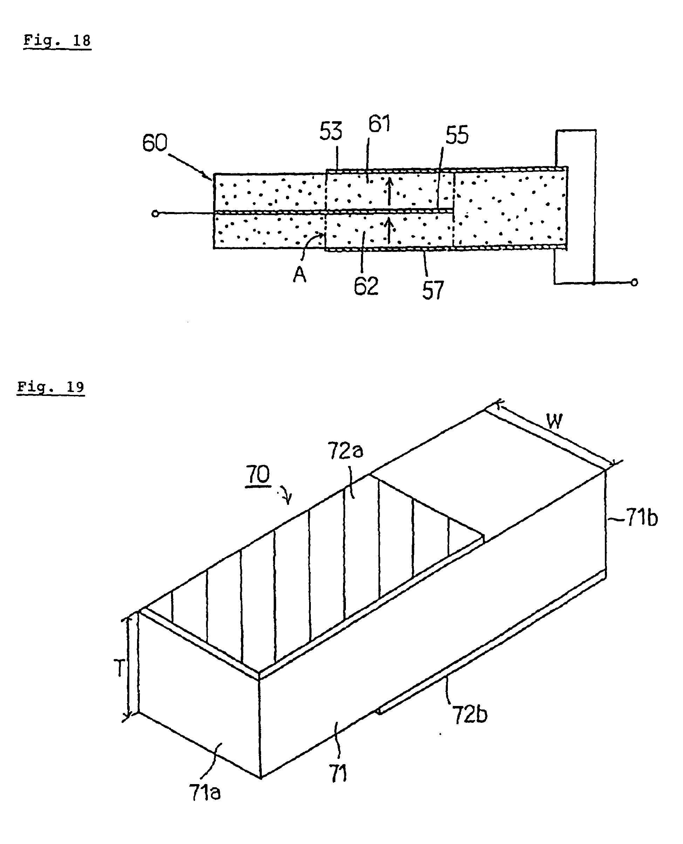

An energy-trapped piezoelectric resonator utilizing the second-order wave of a thickness extensional vibration mode is disclosed in Patent Unexamined Publication No. 117409/1989. This piezoelectric resonator is now described with reference to Figs. 17 and 18.

The above-described piezoelectric resonator is obtained by stacking ceramic green sheets 51, 52 of a piezoelectric material on top of each other and sintering them together, as shown in the exploded perspective view of Fig. 17. A circular excitation electrode 53 is formed in the center of the ceramic green sheet 51. The excitation electrode 53 is brought out to an end of the ceramic green sheet 51 by an extraction electrode 54. A circular excitation electrode 55 is formed in the center of the top surface of the ceramic green sheet 52. The excitation electrode 55 is brought out to an end of the ceramic green sheet 52 by an extraction electrode 56. As shown in the lower projected view, an excitation electrode 57 is formed on the bottom surface of the ceramic green sheet 52. The excitation electrode 57 is brought out to an end of the ceramic green sheet 52 by an extraction electrode 58.

The aforementioned ceramic green sheets 51 and 52 are stacked on top of each other and pressure is applied in the direction of thickness. Then, they are sintered, thus producing a sintered body. This sintered body is polarized. Thus, a piezoelectric resonator 60 is obtained, as shown in Fig. 18.

In the piezoelectric resonator 60, piezoelectric layers 61 and 62 are polarized uniformly in the direction of the arrows, i.e., in the direction of thickness.

When the device is driven, the excitation electrodes 53 and 57 are connected together, and an AC voltage is applied between the excitation electrodes 53, 57 and the excitation electrode 55. In this way, the piezoelectric resonator 60 can be made to resonate. In this case, the vibration energy is confined to a region where the excitation electrodes 53, 55, 57 superimpose each other, i.e., a resonating portion A.

The prior art piezoelectric resonator 60 making use of harmonics of a thickness extensional vibration mode is designed as an energy-trapped piezoelectric resonator as mentioned above. Therefore, it has needed vibration-attenuating portions around the resonating portion A for attenuating vibrations. That is, vibration-attenuating portions that are large compared with the area of the resonating portion are necessary. Consequently, it has been difficult to promote miniaturization of the piezoelectric resonator 60.

On the other hand, Patent Unexamined Publication No. 235422/1990 discloses an energy-trapped piezoelectric resonator that uses a piezoelectric ceramic strip and hardly needs extra piezoelectric substrate portions around the resonating portion.

Here, as shown in Fig. 19, an excitation electrode 72a and an excitation electrode 72b are formed on the top and bottom surfaces, respectively, of an elongated piezoelectric substrate 71. The excitation electrodes 72a and 72b extend along the whole major dimensions of the piezoelectric substrate 71, and face away from each other in the longitudinal center of the piezoelectric substrate 71 to form a resonating portion. These excitation electrodes 72a and 72b extend to longitudinal ends 71a and 71b, respectively, of the piezoelectric substrate 71.

When the piezoelectric resonator 70 is excited into a thickness extensional vibration mode, unwanted vibrations occur due to the dimensional relation between the width W and the thickness T of the piezoelectric substrate 71. Accordingly, Patent Unexamined Publication No. 235422/1990 teaches that where the fundamental wave is used, W/T = 5.33 should be employed if the resonance frequency is 16 MHz, and that where the third-order wave is employed, setting W/T to approximately 2.87 (where the resonance frequency is approximately 16 MHz) can reduce unwanted spurious waves between resonant and antiresonant frequencies.

As described above, the energy-trapped piezoelectric resonator disclosed in Patent Unexamined Publication No. 117409/1989 and utilizing the second-order wave of a thickness extensional vibration mode needs large vibration-attenuating portions around the resonating portion. Hence, it is difficult to reduce the size of the resonator.

The energy-trapped piezoelectric resonator disclosed in Patent Unexamined Publication No. 235422/1990 necessitates no vibration-attenuating portions at sides of the resonator portion and so miniaturization can be attained. However, where harmonic waves of a thickness extensional vibration mode are utilized, various unwanted spurious waves appear, in addition to the spurious waves between the resonant and antiresonant frequencies. In consequence, effective resonant characteristics are not obtained.

Patent publication US 5 045 744 also discloses an energy-trapped type resonator whose efficiency, however, could be improved.

Accordingly, it is an object of the present invention to provide an energy-trapped thickness extensional vibration mode piezoelectric resonator that utilizes a harmonic wave of a thickness extensional vibration mode and can be fabricated in smaller size and thus can effectively suppress unwanted spurious vibrations (hence have good resonant characteristics).

The present invention provides an energy-trapped type thickness extensional vibration mode piezoelectric resonator utilizing an $n$th-order harmonic of a thickness extensional vibration mode, comprising; a rectangular piezoelectric plate having first and second faces opposite to each other; a first and a second excitation electrodes provided on said first and second faces respectively and opposed to each other via said piezoelectric plate; at least one internal electrode disposed in said piezoelectric plate and at least partially placed opposite to the first and second excitation electrodes; the opposing portion of said first and second excitation electrodes, said internal electrode and said piezoelectric plate defining a resonating portion; vibration-attenuating portions disposed on both sides of said resonating portion along one direction; both said first and second excitation electrodes extending to both ends of the piezoelectric plate in a direction perpendicular to said direction; and said first and second excitation electrodes overlapping each other over a length of $\ell$ such that $\ell/d$ is in a range of 3 to 6 in which $d = t/n$. where t is a thickness of said rectangular piezoelectric plate and $n$ is an integral larger than 1.

By the above described structure, unwanted spurious components due to inharmonic overtones and harmonic waves other than the used harmonic can be suppressed effectively. In consequence, an energy-trapped thickness extensional vibration mode piezoelectric resonator having good resonant characteristics can be provided.

By the above structure, not only spurious components due to inharmonic overtones can be suppressed, but also an energy-trapped thickness extensional vibration mode piezoelectric resonator having a wide relative bandwidth and better resonant characteristics can be realized. More preferably, the ratio $\ell/d$ is in the range of 4.5 to 5.5. This can enlarge the relative bandwidth further.

In the above described energy-trapped thickness extensional vibration mode piezoelectric, the piezoelectric plate is preferably an elongated piezoelectric strip type.

By the above structure, miniaturization of the thickness extensional vibration mode piezoelectric resonator can be promoted.

The above described energy-trapped thickness extensional vibration mode piezoelectric resonator may further comprise a capacitor disposed on said first and second faces of said piezoelectric plate with a space therebetween , the space acting not to impede vibrations of the piezoelectric resonator.

By the above structure, a piezoelectric resonator having a built-in capacitor can be offered, using a piezoelectric resonator having little unwanted spurious vibrations due to inharmonic overtones and good resonant characteristics.

BRIEF DESCRIPTION OF THE DRAWINGS

Fig. 1 is a perspective view showing a thickness extensional vibration mode piezoelectric resonator according to a first embodiment of the invention;
Fig. 2 is a cross-sectional view of the thickness extensional vibration mode piezoelectric resonator according to the first embodiment;
Fig. 3 is a cross-sectional view of a portion of a piezoelectric resonator corresponding to portions whose displacement distributions are shown in Figs. 4 and 5;
Fig. 4 is a diagram illustrating the distribution of displacements in a piezoelectric body vibrating in the second-order wave (TE2) of a thickness extensional vibration, the distribution being analyzed by the finite element method;
Fig. 5 is a diagram illustrating the distribution of displacements in a piezoelectric body vibrating in an inharmonic overtone (S1), the distribution being analyzed by the finite element method;
Fig. 6 is a diagram illustrating the impedance-frequency characteristics analyzed by the finite element method where the ratio $\ell/d$ is 5.0;
Fig. 7 is a diagram illustrating the impedance-frequency characteristics of a thickness extensional vibration mode piezoelectric resonator shown in Fig. 1, the characteristics being analyzed by the finite element method where the ratio $\ell/d$ is 3.0;
Fig. 8 is a diagram illustrating the relations among the ratio $\ell/d$, the second-order wave TE2 of a thickness extensional vibration mode, and the frequency constant of an inharmonic overtone S1;
Fig. 9 is a diagram illustrating the relation between the ratio $\ell/d$ and the relative bandwidth;
Fig. 10 is a perspective view illustrating a thickness extensional vibration mode piezoelectric resonator according to a second emmbodiment of the invention;
Fig. 11 is a cross-sectional view showing a first modified example of a thickness extensional vibration mode piezoelectric resonator according to the invention;
Fig. 12 is a cross-sectional view showing a second modified example of a thickness extensional vibration mode piezoelectric resonator according to the invention;
Fig. 13 is a cross-sectional view showing a third modified example of a thickness extensional vibration mode piezoelectric resonator according to the invention;
Fig. 14 is a cross-sectional view showing a fourth modified example of a thickness extensional vibration mode piezoelectric resonator according to the invention;
Fig. 15 is a perspective view showing a piezoelectric resonator having a built-in capacitor, the resonator being built according to the third embodiment of the invention;

Fig. 16 is a diagram showing the circuit configuration of the piezoelectric resonator shown in Fig. 15;

Fig. 17 is an exploded perspective view illustrating one example of the prior art thickness extensional vibration mode piezoelectric resonator;

Fig. 18 is a cross-sectional view of the thickness extensional vibration mode piezoelectric resonator shown in Fig. 17;

Fig. 19 is a perspective view illustrating another example of the prior art thickness extensional vibration mode piezoelectric resonator; and

Fig. 20 is a diagram illustrating the impedance-frequency characteristics of the prior art thickness extensional vibration mode piezoelectric resonator.

PREFERRED EMBODIMENTS OF THE PRESENT INVENTION

Other features and advantages of the present invention will become apparent from the following description of the invention which refers to the accompanying drawings.

(First Embodiment)

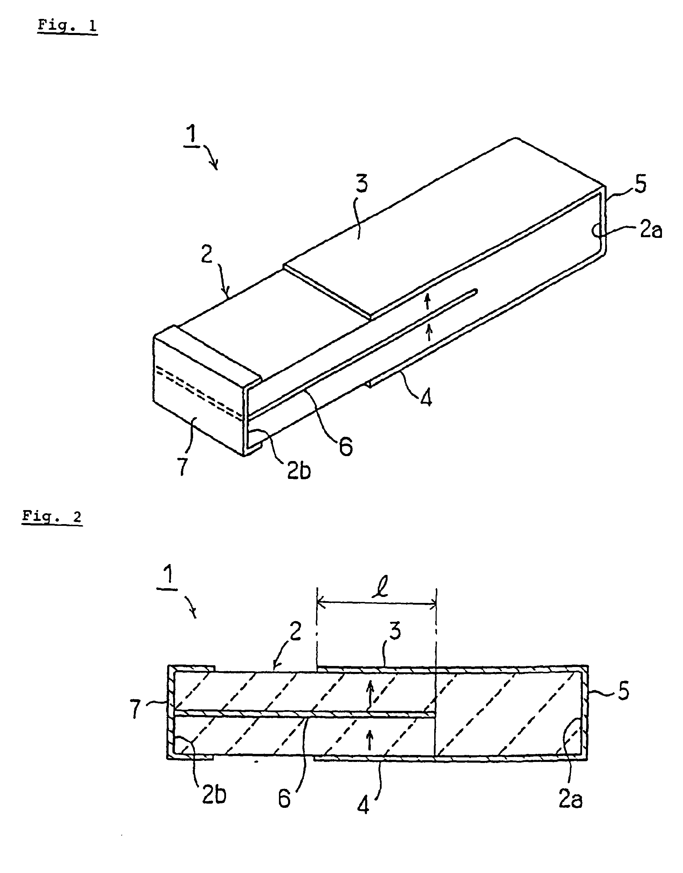

Fig. 1 is a perspective view showing a thickness extensional vibration mode piezoelectric resonator according to a first embodiment of the invention. Fig. 2 is a cross-sectional view of the resonator.

A thickness extensional piezoelectric resonator 1 is made of an elongated piezoelectric strip 2 consisting of a piezoelectric ceramic such as a lead zirconate titanate-based ceramic.

The piezoelectric strip 2 is polarized uniformly in the direction of thickness as indicated by the arrows in the figure. A first excitation electrode 3 is formed on the top surface of the piezoelectric strip 2. A second excitation electrode 4 is formed on the bottom surface. Excitation electrodes 3 and 4 extend from one end surface 2a of the piezoelectric strip 2 to the other end surface 2b at the top and bottom surfaces of the piezoelectric strip 2.

The excitation electrodes 3 and 4 are connected together by a connecting electrode 5 formed on the end surface 2a of the piezoelectric strip 2.

An internal electrode 6 is formed at a midway level within the piezoelectric strip 2. The internal electrode 6 is brought out to the end surface 2b of the piezoelectric strip 2, and is electrically connected with a terminal electrode 7 formed on the end surface 2b.

During operation, an AC voltage is applied between the first and second excitation electrodes 3, 4 and the internal electrode 6, thus inducing the second-order wave of the thickness extensional vibration mode strongly. In this way, the resonator can be used as a piezoelectric resonator utilizing the second-order wave.

The first and second excitation electrodes 3 and 4 are stacked over the internal electrode 6 via the piezoelectric layer in the longitudinal center of the piezoelectric strip 2. Therefore, in the portion where the internal electrode 6 overlaps the first and second excitation electrodes 3, 4, an energy-trapped resonating portion is formed. When this resonating portion is resonating, the energy is attenuated by the piezoelectric portions extending from the resonating portion to the end surfaces 2a and 2b.

If the above-described resonating portion is taken as the center, vibration-attenuating portions are formed at longitudinally opposite sides only in the longitudinal direction of the piezoelectric strip 2. The first and second excitation electrodes extend to the ends of the piezoelectric strip in a direction perpendicular to the longitudinal direction, i.e., to the longitudinal ends.

In this case, the first and second excitation electrodes 3, 4 and the internal electrode 6 are only required to extend along the whole width of the piezoelectric strip 2 only in the resonating portion 6. Outside the resonating portion, this width is not always required to be maintained. Take the excitation electrode 3 as an example. The excitation electrode 3 only needs to extend along the whole width of the piezoelectric strip 2 only in the resonating portion. The portion of the excitation electrode on the side of the end surface 2a may be thinner, because it simply electrically connects the excitation electrode with the connecting electrode 5.

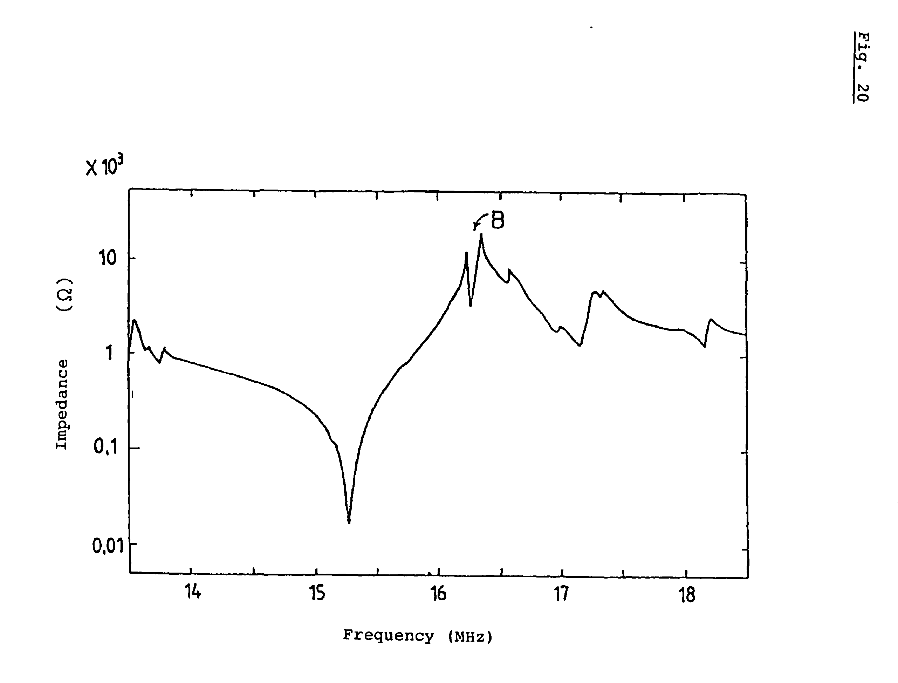

The present embodiment is characterized in that the ratio $\ell$/d is set not greater than 6, where $\ell$ is the length of the overlap between the first and second excitation electrodes 3, 4 in a first direction, or the longitudinal direction of the piezoelectric plate 2 that connects the vibration-attenuating portions on both sides of the resonating portion, t is the thickness of the piezoelectric plate 2, and d = t/$n$. In particular, in the energy-trapped thickness extensional vibration mode piezoelectric resonator 1, the ratio $\ell$/d is set not greater than 6. Therefore, the resonator can effectively suppress unwanted spurious components, unlike the prior art strip-type thickness extensional vibration mode piezoelectric resonator. This will be described with reference to Figs. 20 and 3-9.

The impedance-frequency of the prior art strip-type piezoelectric resonator 70 shown in Fig. 19 is depicted in Fig. 20. As can be seen from Fig. 20, it can be observed that in responses to the second-order wave of a thickness extensional vibration mode, waveform division takes place near the antiresonant point as indicated by the arrow B and thus the resonant characteristic in the band between the resonant and the antiresonant frequencies is deteriorated.

Accordingly, the inventors of the present application carried out various discussions on the cause of the waveform division indicated by the arrow B and have discovered that the waveform division is due to spurious vibrations known as inharmonic overtones. Also, we have first found that the effects of the inharmonic overtones can be suppressed by adjusting the aforementioned ratio $\ell$/d and made the present invention.

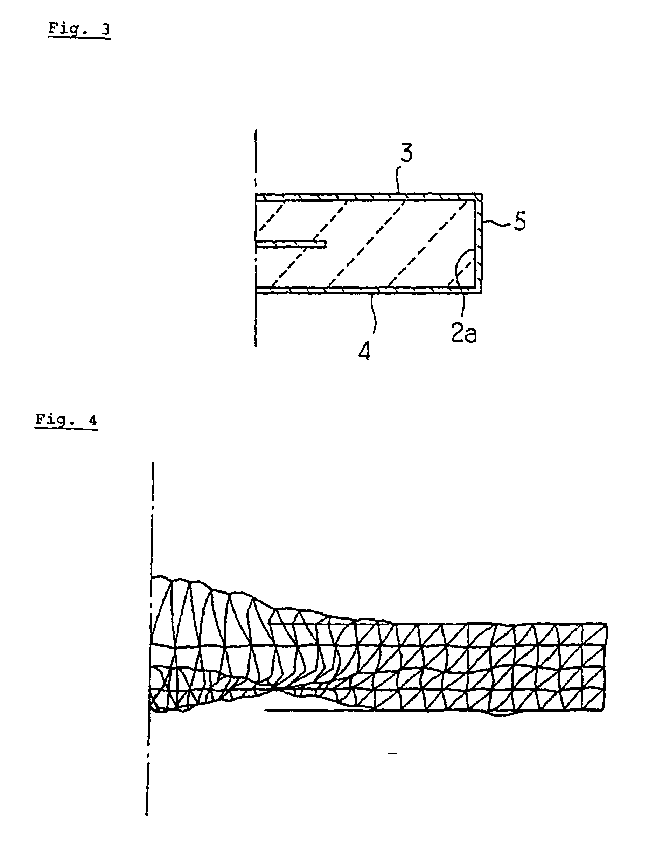

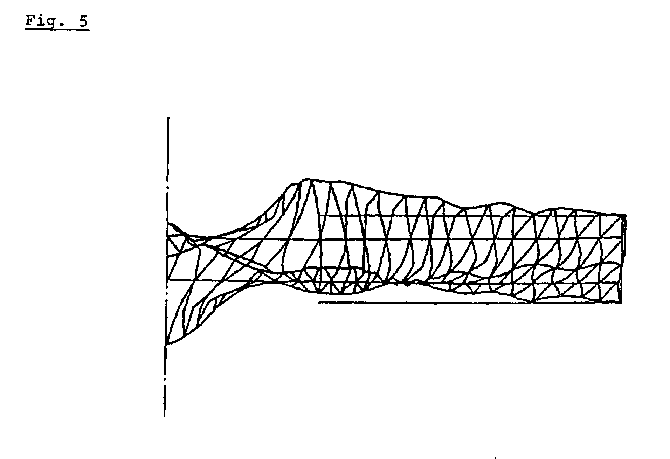

Figs. 4 and 5 are diagrams illustrating the distributions of displacements analyzed by the finite element method when the second-order wave (TE2) of a thickness extensional vibration and an inharmonic overtone (S1 mode) are excited. Figs. 4 and 5 schematically show the displacements on a half of a vertically cut surface across a strip-type thickness extensional vibration mode piezoelectric resonator 1 shown in Fig. 3, i.e., a half of a plane cut across the thickness extensional vibration mode piezoelectric resonator along the longitudinal direction and in the direction of thickness.

As can be seen from Fig. 5, the inharmonic overtone greatly displaces the piezoelectric plate in the resonating portion of the thickness extensional vibration mode piezoelectric resonator. It is observed that if such an inharmonic overtone is produced with a large amplitude, vibration of the second-order wave of the thickness extensional vibration mode shown in Fig. 4 is affected materially.

Accordingly, the inventors of the present application performed various experiments in an attempt to suppress spurious components attributed to the inharmonic overtone S1 described above and have found that the response to the inharmonic overtone can be reduced by setting the ratio $\ell$/d to not greater than 6, where $\ell$ is the length of the overlap between the first and second excitation electrodes in the longitudinal direction of the piezoelectric plate 1, t is the thickness of the piezoelectric plate 2, and d = t/$n$., and that only the second-order wave TE2 of the thickness extensional vibration mode can be excited strongly.

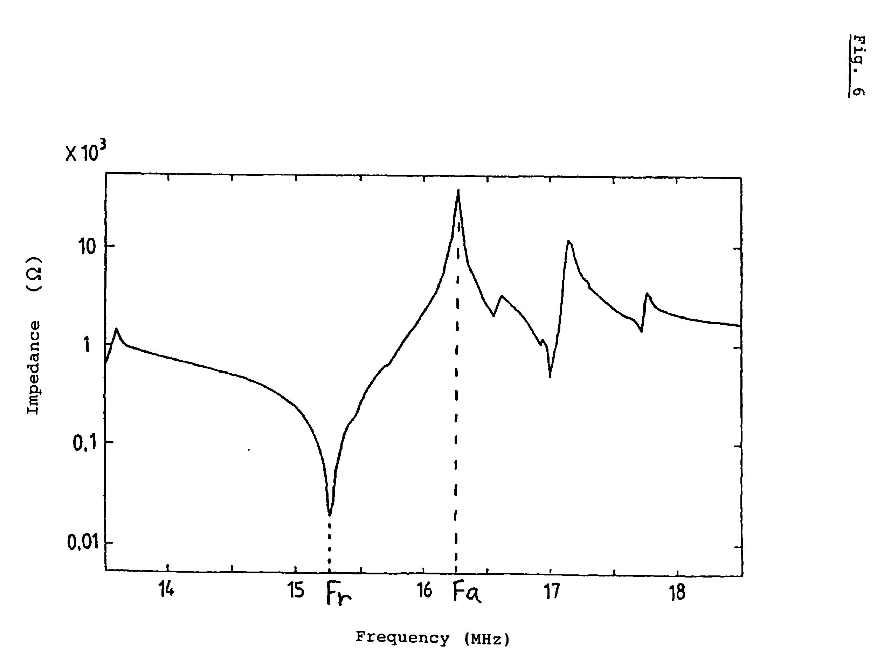

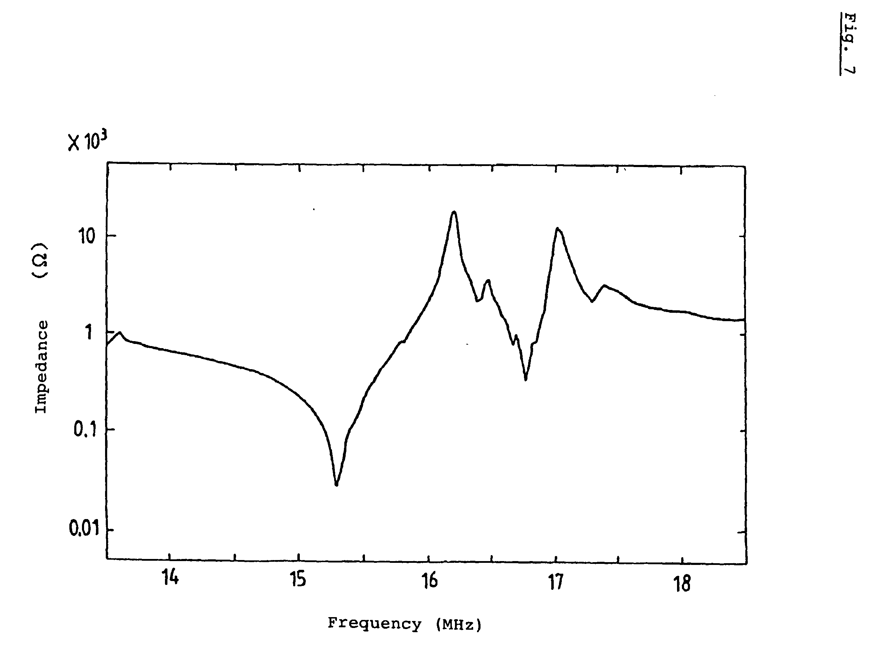

Figs. 6 and 7 show the impedance-frequency characteristics of the piezoelectric resonator 1 where the ratio $\ell$/d is set to 5.0 and 3.0, respectively.

As can be seen from Fig. 6, where the ratio $\ell$/d is 5.0, no great spurious vibrations are produced near the passband between the resonant point Fr and the antiresonant point Fa. Therefore, the spurious components due to the inharmonic overtone can be suppressed effectively.

As will be noted from Fig. 7, where the ratio $\ell$/d is 3.0, no waveform division takes place near the antiresonant point Fa as shown in Fig. 20. Consequently, spurious components due to the inharmonic overtone can be suppressed.

Comparison of the characteristic shown in Fig. 6 with the characteristic shown in Fig. 7 shows that the response to the spurious component can be more effectively suppressed in the case where the ratio $\ell$/d = 5.0 than in the case where the ratio $\ell$/d

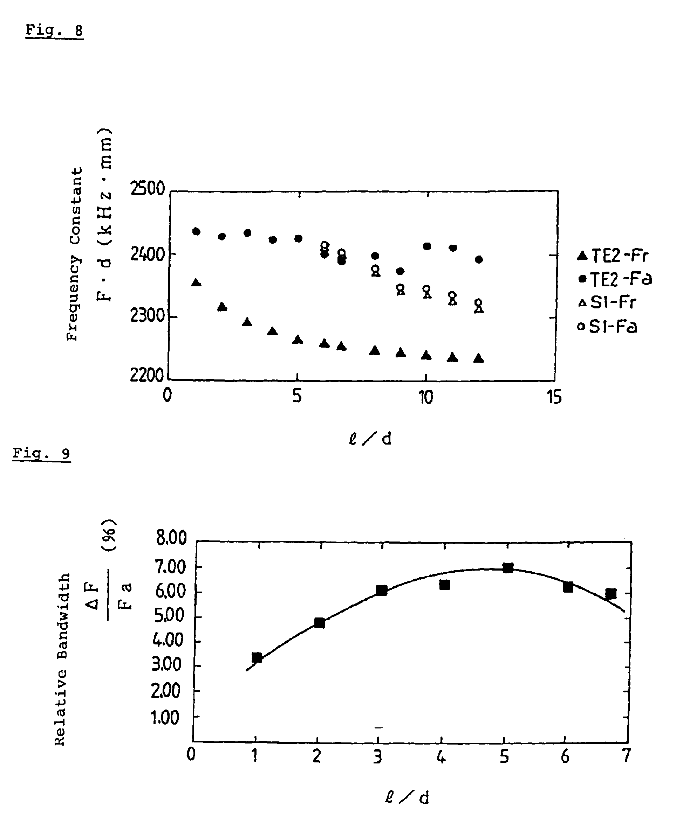

A piezoelectric ceramic made of a lead titanate having a length L = 3.0 mm, a width W = 0.5 mm, and a thickness t = 0.3 mm was used as the piezoelectric plate 1. The dimension $\ell$ of the overlap between the first and second excitation electrodes in the longitudinal direction was changed to various values. Variations in the resonant characteristics with the ratio $\ell$/d were examined. The results are shown in Figs. 8 and 9.

Fig. 8 is a diagram illustrating the variations in the frequency constant F · d where the ratio $\ell$/d changed. The frequency constant F · d is a value expressed in terms of the product of the frequency at the resonant point Fr or antiresonant point Fa and the above-described d.

In Fig. 8, ▲ indicates the resonant point Fr of the second-order wave (TE2) of a thickness extensional vibration mode, ● indicates the antiresonant point Fa of the second-order wave (TE2) of the thickness extensional vibration mode, △ indicates the antiresonant point Fr of the inharmonic overtone (S1), and O indicates the position of the antiresonant point Fa of the inharmonic overtone (S1).

As can be seen from Fig. 8, where $\ell$/d = 6 is exceeded, the resonant point Fr and the antiresonant point Fa of the inharmonic overtone S1 appear near the antiresonant point Fa of the second-order wave TE2 of a thickness extensional vibration. Where the ratio $\ell$/d is not less than 8, they are produced in the band between the resonant point Fr and the antiresonant point Fa of the second-order wave TE2 of the thickness extensional vibration. On the other hand, where $\ell$/d is not greater than 6, no inharmonic overtone appears.

Where the ratio $\ell$/d is not greater than 6, the generation of inharmonic overtones can be suppressed. However, as the ratio $\ell$/d decreases, the passband for the second-order wave TE2 of the thickness extensional vibration mode, i.e., the bandwidth between the resonant point Fr and the antiresonant point Fa, narrows.

We checked, by the finite element method, the relative bandwidth when the ratio $\ell$/d was varied. Results shown in Fig. 9 were derived.

The relative bandwidth is given by

$$(Fa - Fr) \times 100 / Fa \, (\%)$$ where Fr is a resonant frequency and Fa is an antiresonant frequency.

As can be seen from Fig. 9, as the ratio $\ell$/d is varied, the relative bandwidth changes. Where $\ell$/d is in the range of 3 to 6, the relative bandwidth is as large as 6% or more. Especially, in the range of 4.5 to 5.5, the relative bandwidth is as large as about 7%.

Therefore, spurious components due to inharmonic overtones can be suppressed by setting the ratio $\ell$/d to 3-6, preferably 4.5-5.5. In addition, a large relative bandwidth and good resonant characteristics can be imparted to the energy-trapped thickness extensional vibration mode piezoelectric resonator 1.

In the thickness extensional vibration mode piezoelectric resonator 1 according to the present embodiment, the $\ell$/d is set not greater than 6 as described above. Therefore, where an energy-trapped piezoelectric resonator is constructed, utilizing the second-order wave TE2 of a thickness extensional vibration mode, unwanted spurious components due to inharmonic overtones can be suppressed effectively.

(Second Embodiment)

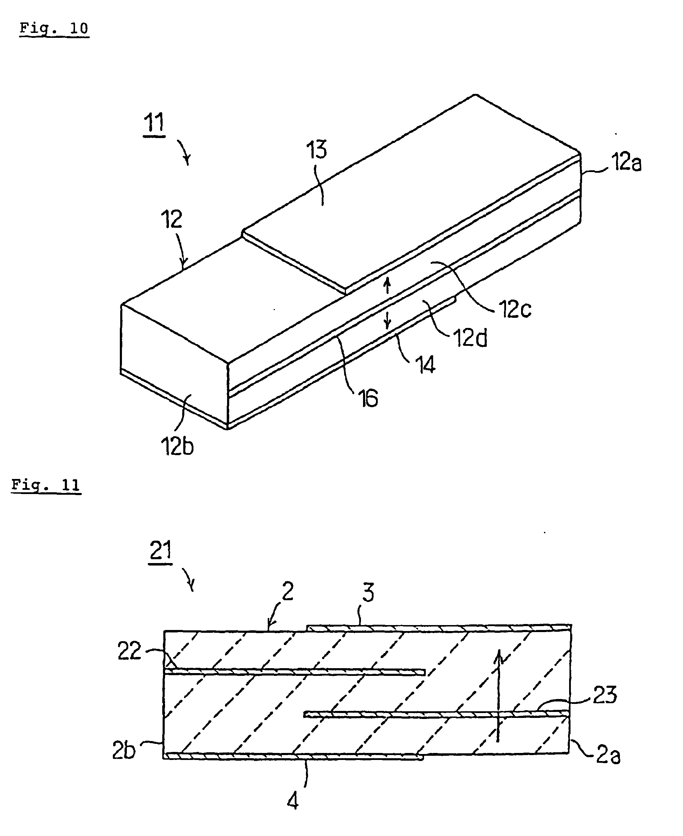

In the thickness extensional vibration mode piezoelectric resonator 1 according to the first embodiment, the piezoelectric strip 2 is polarized uniformly in the direction of thickness. The piezoelectric resonator is connected in a parallel configuration such that the applied electric field is reversed with each of the successive layers. The invention may also be applied to a series-connection type piezoelectric resonator in which plural piezoelectric layers are polarized alternately oppositely in the direction of thickness. A thickness extensional vibration mode piezoelectric resonator of such a series type is shown in Fig. 10.

A thickness extensional vibration mode piezoelectric resonator, 11, shown in Fig. 10 is made of an elongated rectangular piezoelectric strip 12. A first excitation electrode 13 is formed on the top surface of the piezoelectric strip 12. A second excitation electrode 14 is formed on the bottom surface. The first and second excitation electrodes 13 and 14, respectively, are located on opposite side of the piezoelectric strip 12. The first and second excitation electrodes 13 and 14 are opposite to each other in the longitudinal center of the piezoelectric strip 12. The portion where the first and second excitation electrodes 13 and 14 are opposite to each other makes an energy-trapped resonator portion.

Also, in the present embodiment, the first and second excitation electrodes 13 and 14 are brought out to end surfaces 12a and 12b, respectively, of the piezoelectric strip 12. The portions other than the resonator portion are not required to extend along the whole length of the piezoelectric strip 12.

From a different viewpoint, the excitation electrodes 13 and 14 form an energy-trapped resonator portion having vibration-attenuating portions in the longitudinal direction of the piezoelectric strip 12. For this purpose, the first and second excitation electrodes 13 and 14 extend to the longitudinal ends of the piezoelectric strip 12 in a direction vertical to the longitudinal direction.

An internal electrode 16 is formed at a midway height within the piezoelectric strip 12, and acts to polarize the piezoelectric strip 12. That is, during polarization, piezoelectric layers 12c and 12d are polarized in opposite directions in the direction of thickness as indicated by the arrows by applying a higher voltage and a lower voltage to the internal electrode 16 and the excitation electrodes 13, 14, respectively.

During operation, an AC voltage is applied between the first and second excitation electrodes 13 and 14, respectively. That is, the internal electrode 16 is not used for the operation. The second-order wave $TE_2$ of a thickness extensional vibration mode can be excited.

Also, in the thickness extensional vibration mode piezoelectric resonator 11 according to the second embodiment, the ratio $\ell/d$ is set not greater than 6 and so the resonator can effectively suppress unwanted spurious components due to inharmonic overtones in the same way as the thickness extensional vibration mode piezoelectric resonator 1 according to the first embodiment. Also, good resonant characteristics can be obtained.

(Modified Example)

The first and second embodiments provide piezoelectric resonators 1 and 11 both utilizing the second-order wave of a thickness extensional vibration mode. Piezoelectric resonators in accordance with the present invention may make use of harmonics other than the second-order wave of a thickness extensional vibration mode. Figs. 11-14 are cross-sectional views illustrating piezoelectric resonators utilizing these other harmonics, and correspond to Fig. 2 used to describe the first embodiment.

Fig. 11 is a parallel-connection type thickness extensional vibration mode piezoelectric resonator, 21, utilizing the third-order wave of a thickness extensional vibration mode. In particular, two internal electrodes 22 and 23 are disposed in a piezoelectric body 2. The piezoelectric body 2 is polarized uniformly in the direction of thickness as indicated by the arrow. Thus, the piezoelectric resonator 21 exploiting the third-order wave of a thickness extensional vibration mode can be built.

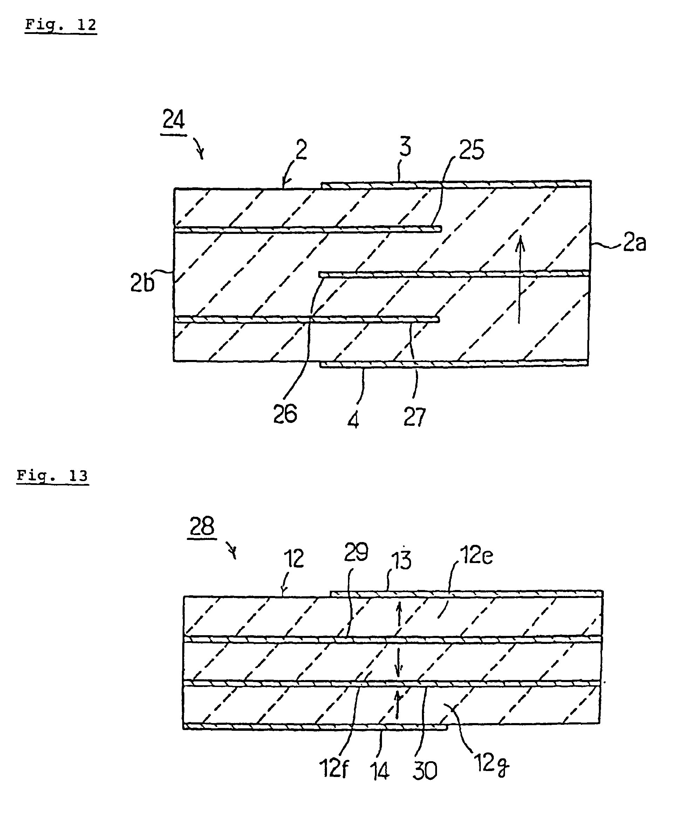

A thickness extensional vibration mode piezoelectric resonator, 24, shown in Fig. 12 is a cross-sectional view showing a parallel-connection type piezoelectric resonator 24 utilizing the fourth-order wave of a thickness extensional vibration mode. In the thickness extensional vibration mode piezoelectric resonator 24, the piezoelectric strip 2 is polarized uniformly in the direction of thickness. Three internal electrodes 25-27 are regularly spaced from each other in the direction of thickness inside the resonator. Consequently, the fourth-order wave of a thickness extensional vibration mode is effectively excited.

Fig. 13 is a cross-sectional view showing a series-connection type thickness extensional vibration mode piezoelectric resonator, 28, utilizing the third-order wave of a thickness extensional vibration mode. In this thickness extensional vibration mode piezoelectric resonator 28, two internal electrodes 29 and 30 are disposed in a piezoelectric body 12. The inside of the piezoelectric body 12 is divided into three layers of piezoelectric layers 12e-12g. Polarization is performed, using these internal electrodes 29 and 30, so that piezoelectric layers adjacent to each other in the direction of thickness are polarized in opposite directions. Thus, the third-order wave of a thickness extensional vibration mode can be excited by applying an AC voltage to the first and second excitation electrodes 13 and 14.

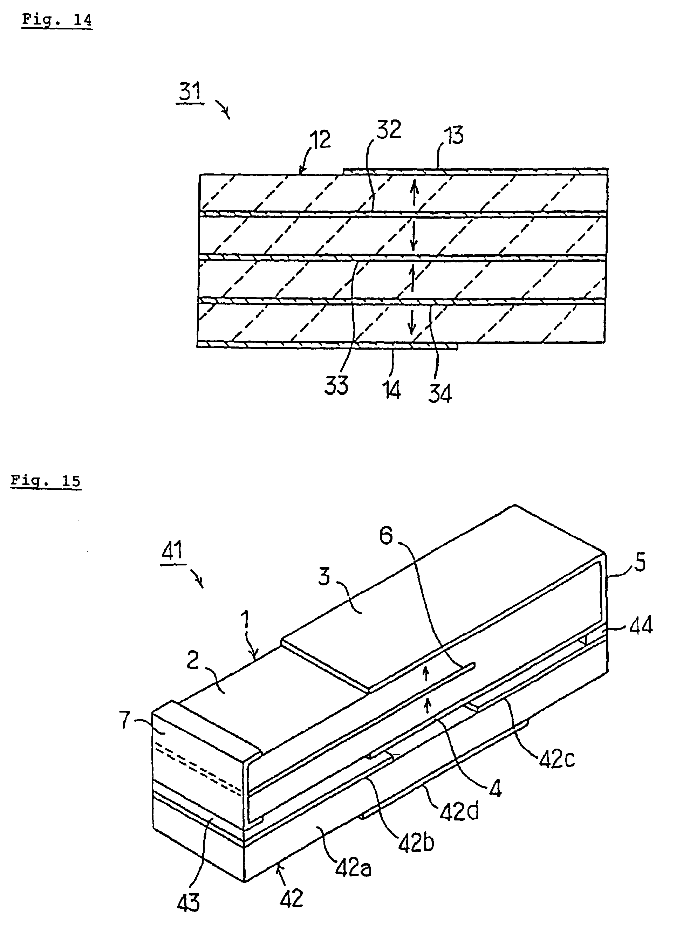

Similarly, Fig. 14 is a cross-sectional view showing a series-connection type piezoelectric resonator, 31, utilizing the fourth-order wave of a thickness extensional vibration mode. Here, three internal electrodes 32-34 are disposed in a piezoelectric body 12. Polarization is carried out, using these internal electrodes 32-34, such that piezoelectric layers adjacent to each other in the direction of thickness are polarized in opposite directions.

Therefore, it can be operated as a piezoelectric resonator utilizing the fourth-order wave of a thickness extensional vibration, by applying an AC voltage from the first and second excitation electrodes 13 and 14, respectively.

In each thickness extensional vibration mode piezoelectric resonator shown in Figs. 11-14, the ratio $\ell$/d is also set not greater than 6. In consequence, they can effectively suppress unwanted spurious components due to responses to inharmonic overtones by making use of a harmonic wave of a thickness extensional vibration, in the same way as the thickness extensional vibration mode piezoelectric resonators according to the first and second embodiments.

(Third Embodiment)

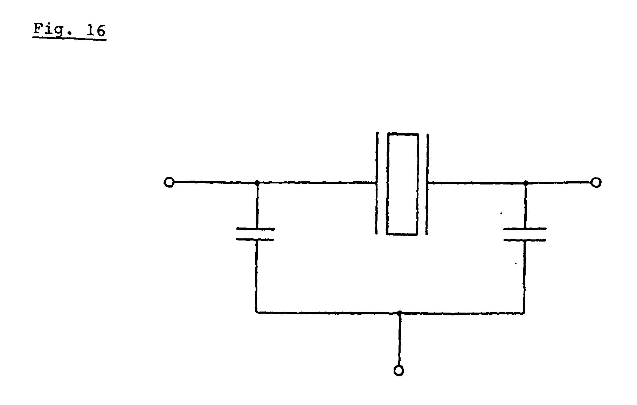

Fig. 15 is a perspective view for illustrating a thickness extensional vibration mode piezoelectric resonator according to a third embodiment of the invention. Fig. 16 is a diagram showing its equivalent circuit. Fig. 15 shows a piezoelectric resonator 41 that is a combination of the thickness extensional vibration mode piezoelectric resonator 1 according to the first embodiment and a capacitor 42. This capacitor 42 is bonded to the bottom surface of the thickness extensional vibration mode piezoelectric resonator 1 via conductive adhesive 43, 44.

In the capacitor 42, capacitive electrodes 42b and 42c are formed via a given gap on the top surface of a dielectric substrate 42a. A common electrode 42d is formed on the bottom surface of the dielectric substrate 42a. The common electrode 42d and the capacitive electrodes 42b, 42c are located on opposite sides of the dielectric substrate 42a.

The conductive adhesive 43 bonds the capacitive electrode 42b to a terminal electrode 7. The conductive adhesive 44 bonds the capacitive electrode 42c to a terminal electrode 5.

Therefore, as shown in Fig. 16, the piezoelectric resonator 41 can be used as a piezoelectric resonator incorporating two capacitive units.

Thus, the thickness extensional vibration mode piezoelectric resonator 1 is a piezoelectric resonator utilizing the second-order waves of thickness extensional vibrations. Spurious vibrations attributed to inharmonic overtones can be effectively suppressed. Therefore, piezoelectric resonators having good frequency characteristics can be offered.

While the invention has been particularly shown and described with reference to preferred embodiments thereof, it will be understood by those skilled man in the art that the foregoing and other changes in form and details may be made therein without departing from the scope of the invention as defined by the following claims.

**Claims**

1. An energy-trapped type thickness extensional vibration mode piezoelectric resonator (1) utilizing an *n*th-order harmonic of a thickness extensional vibration mode, comprising;

   a rectangular piezoelectric plate (2) having first and second faces opposite to each other;
   a first (3) and a second (4) excitation electrodes provided on said first and second faces respectively and opposed to each other via said piezoelectric plate (2);
   at least one internal electrode (6) disposed in said piezoelectric plate (2) and at least partially placed opposite to the first (3) and second (4) excitation electrodes;
   the opposing portion of said first (3) and second (4) excitation electrodes, said internal electrode (6) and said piezoelectric plate (2) defining a resonating portion;
   vibration-attenuating portions disposed on both sides of said resonating portion along one direction;
   both said first (3) and second (4) excitation electrodes extending to both ends of the piezoelectric plate (2) in a direction perpendicular to said direction, and
   said first (3) and second (4) excitation electrodes overlapping, each other over a length of $\ell$ such that the ratio $\ell$/d is in a range of 3 to 6, in which d = t/$n$, where t is the thickness of said rectangular piezoelectric plate (2) and $n$ is an integral larger than 1.

2. The energy-trapped thickness extensional vibration mode piezoelectric resonator according to claim 1, wherein said piezoelectric plate is an elongated piezoelectric strip type.

3. The energy-trapped thickness extensional vibration mode piezoelectric resonator according to one of claims 1 or 2, further comprising a capacitor disposed on said first and second faces of said piezoelectric plate with a space therebetween, the space acting not to impede vibrations of the piezoelectric resonator.

**Patentansprüche**

1. Ein piezoelektrischer Resonator (1) in der Dickeausdehnungsschwingungsmode des Typs mit eingefangener Energie unter Verwendung einer harmoni-

schen Dikkeausdehnungsschwingungsmode *n*-ter Ordnung, umfassend:

eine rechteckige piezoelektrische Platte (2) mit ersten und zweiten einander gegenüberliegenden Flächen;

eine erste (3) und eine zweite (4) Anregungselektrode, die auf der ersten bzw. zweiten Fläche vorgesehen sind und über die piezoelektrische Platte (2) einander gegenüberliegen;

mindestens eine innere Elektrode (6), die in der piezoelektrischen Platte (2) angeordnet ist und mindestens teilweise gegenüber der ersten (3) und zweiten (4) Anregungselektrode platziert ist;

wobei der gegenüberliegende Teil der der ersten (3) und zweiten (4) Anregungselektrode, die innere Elektrode (6) und die piezoelektrische Platte (2) einen Resonanzteil definieren; schwingungsdämpfende Teile, die auf beiden Seiten des Resonanzteils entlang einer Richtung angeordnet sind;

wobei sowohl die erste (3) als auch zweite (4) Anregungselektrode sich bis zu beiden Enden der piezoelektrischen Platte (2) in einer Richtung senkrecht zu der Richtung erstrecken; und

wobei die erste (3) und eine zweite (4) Anregungselektrode sich gegenseitig über eine Länge von *l* so überlappen, dass das Verhältnis *l*/D in einem Bereich von 3 bis 6 liegt,

wobei d = t/*n*, wobei t die Dicke der rechteckigen piezoelektrischen Platten (2) ist und *n* eine ganze Zahl von größer als 1 ist.

**2.** Der piezoelektrische Resonator in der Dickeausdehnungsschwingungsmode des Typs mit eingefangener Energie nach Anspruch 1, wobei die piezoelektrische Platte ein länglicher piezoelektrischer Streifen ist.

**3.** Der piezoelektrische Resonator in der Dickeausdehnungsschwingungsmode des Typs mit eingefangener Energie nach einem der Ansprüche 1 oder 2, der weiterhin einen Kondensator beinhaltet, der auf der ersten und zweiten Fläche der piezoelektrischen Platte mit einem Raum dazwischen angeordnet ist, wobei der Raum dahingehend wirkt, die Schwingungen des piezoelektrischen Resonators nicht zu beeinträchtigen.

## Revendications

**1.** Un résonateur piézoélectrique à piégeage d'énergie en mode de vibration d'extension d'épaisseur (1) utilisant un ordre harmonique *n* de mode de vibration d'extension d'épaisseur, comprenant :

une plaque piézoélectrique rectangulaire (2) ayant la première et la seconde face opposées l'une à l'autre ;

une première (3) et une seconde (4) électrode fournies respectivement sur lesdites premières et secondes faces et opposées l'une à l'autre via la plaque piézoélectrique (2) ;

au moins une électrode interne (6) disposée dans ladite plaque piézoélectrique (2) et au moins partiellement placée à l'opposé de la première (3) et de la seconde (4) électrode d'excitation ;

la portion opposée de ladite première (3) et de la seconde (4) électrodes d'excitation, ladite électrode interne (6) et de ladite plaque piézoélectrique (2) définissant une portion résonante ;

des portions atténuant les vibrations disposées sur les deux côtés de ladite portion résonante selon une direction ;

les deux dites premières et secondes électrodes d'excitation s'étendant aux deux extrémités de la plaque piézoélectrique (2) dans une direction perpendiculaire à ladite direction ; et

ladite première (3) et seconde (4) électrode d'excitation se chevauchent l'une l'autre sur une longueur de *l* de telle manière que le rapport *l*/d varie de 3 à 6, dans laquelle d = t/n, où t est l'épaisseur de ladite plaque piézoélectrique rectangulaire (2) et *n* est une intégrale supérieure à 1.

**2.** Le résonateur piézoélectrique à piégeage d'énergie en mode de vibration d'extension d'épaisseur selon la revendication 1, dans laquelle ladite plaque piézoélectrique est un type de bande piézoélectrique allongée.

**3.** Le résonateur piézoélectrique à piégeage d'énergie en mode de vibration d'extension d'épaisseur selon l'une des revendications 1 ou 2, comprenant en plus un condensateur disposé sur ladite première et seconde face de ladite plaque piézoélectrique avec un espace entre les deux, l'espace agissant pour ne pas empêcher les vibrations du résonateur piézoélectrique.

Fig. 1

Fig. 2

Fig. 3

Fig. 4

Fig. 5

Fig. 6

Fig. 7

Fig. 8

Fig. 9

14

Fig. 10

Fig. 11

Fig. 12

Fig. 13

Fig. 14

Fig. 15

Fig. 16

Fig. 17

Fig. 18

Fig. 19

Fig. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 1174091989 A
- WO 2354221990 A

- US 5045744 A